# EUROPÄISCHE PATENTSCHRIFT

(11) **EP 0 787 819 B1**
(45) Veröffentlichungstag und Bekanntmachung des Hinweises auf die Patenterteilung: **22.12.1999**
(21) Anmeldenummer: 96118980.0
(22) Anmeldetag: 27.11.1996
(51) Int. Cl.: C23C 14/34, B23K 35/26

(54) **Sputtertarget aus einer Zinn- oder Zinn-Basislegierung**
Tin or tin base alloy sputtering target
Cible de pulvérisation en étain ou alliage à base d'étain

(30) Priorität: 31.01.1996 DE 19603360; 16.11.1996 DE 19647478
(43) Veröffentlichungstag der Anmeldung: 06.08.1997
(73) Patentinhaber: LEYBOLD MATERIALS GmbH, D-63450 Hanau (DE)
(72) Erfinder: Weigert, Martin, Dr., 63457 Hanau (DE); Schultheis, Markus, 36043 Fulda (DE)

(56) Entgegenhaltungen:
- DE-C- 4 131 181
- US-A- 4 392 939
- US-A- 5 066 381
- APPLIED PHYSICS LETTERS, Bd. 64, Nr. 5, 31.Januar 1994, US, Seiten 580-582, XP000422908 MCCORMACK M ET AL: "SUPPRESSION OF MICROSTRUCTURAL COARSENING AND CREEP DEFORMATION IN A LEAD-FREE SOLDER"

## Beschreibung

Die Erfindung betrifft ein Sputtertarget aus Zinn oder einer Zinn-Basislegierung mit einer mit dem abzusputternden Werkstoff durch Löten verbundenen Rückplatte.

Sputtertargets aus Zinn oder Zinn-Basislegierungen werden hauptsächlich in der Architekturglasbeschichtung zur Herstellung von Wärmedämmschichten durch reaktives Kathodenzerstäuben eingesetzt. Die Sputterkathode besteht aus einer Kathodenrückplatte mit Kühlsystem, Magnetsystem und Spannungsversorgung sowie dem zum Verbrauch bestimmten Sputtertarget. Das Sputtertarget wird üblicherweise durch einen Weichlötprozeß ganzflächig auf die Kathodenrückplatte gelötet. Beim Löten des Sputtertargets auf die Kathodenrückplatte ist darauf zu achten, daß die Lötverbindung möglichst wenig Fehlstellen oder Poren aufweist, da durch Fehlstellen die Wärmeabfuhr der Sputterleistung derartig gestört werden kann, daß im Fall von Zinn-Targets sogar ein Aufschmelzen der Oberfläche auftreten kann.

Beim ganzflächigen Verbinden von Zinn-Sputtertargets mit der Kathodenrückplatte muß ein Lot mit einem Schmelzpunkt unter dem Schmelzpunkt des Zinns verwendet werden. Da Kathodenrückplatten außerdem weichgelötete Anschlüsse aufweisen, kann in vielen Fällen das Target nur mit einem Lot befestigt werden, dessen Schmelzpunkt unter 170°C liegt. Üblicherweise verwendet man Indium-Basis-Legierungen oder Zinn-Indium-Eutektikum als Lot.

Der Nachteil bei der Verwendung von Indium liegt in den hohen Lotkosten des relativ seltenen Metalls Indium.

Ein Lot aus einem eutektischen Gefüge mit 57 gew.% Wismut und 43 gew.% Zinn elektrischen und mechanischen Verbindungen zwischen Bauteile ist aus Applied Physics Letters 64 (1994) 31. Januar, Nr. 5, 580-582 bekannt.

Aufgabe der vorliegenden Erfindung ist es, ein kostengünstiges Ersatzlot für die teueren Indium-Basis-Legierungen zu finden, das eine Arbeitstemperatur unter 170°C ermöglicht, das eine ähnliche thermische Stabilität wie Indium-Basislot aufweist, das mindestens genau so geringe Fehlstellen- und Porenhäufigkeit aufweist wie Indium-Basislot und das nur in geringfügiger Tiefe in das Targetmaterial Zinn eindringt.

Die Aufgabe wird erfindungsgemäß dadurch gelöst, daß der Targetwerkstoff mit einer Lotlegierung, bestehend aus den Legierungselementen
- Wismut: 27 bis 68 gew.%
- Zinn: 32 bis 73 gew.%
sowie weiteren Elementen mit dem Gehalt kleiner 5 gew.% aus der Gruppe der Elemente Indium, Antimon, Blei, Silber oder Kupfer auf der Rückplatte befestigt ist.

Überraschenderweise zeigt sich, daß der fehlerhaft gelötete Flächenanteil noch geringer ist als der mit Indium-Basislot üblicherweise erreichte Fehleranteil. Besonders gute Ergebnisse sind erzielbar, wenn als Lot die eutektische Legierung aus Bi57Sn43 gew.% benutzt wird. In jedem Fall beträgt die Eindringtiefe der Lotlegierung in das Targetmaterial weniger als 400 µm, d.h. bei einer Targetdicke von 14 mm ist nicht mit einer Beeinträchtigung der Sputterschicht zu rechnen.

### Beispiele:

1. Ein Zinn-Sputtertarget 3694 mm Länge, 232 mm Breite und 14 mm Dicke wird gleichmäßig auf 170°C erwärmt. Die Kathodenrückplatte aus Kupfer wird ebenfalls auf 170°C erwärmt. Die Rückseite des Sputtertargets wird mit vorverflüssigtem Bi57Sn43 gew.%-Lot unter Verwendung eines fusselfreien und hitzebeständigen Tuchs benetzt. Die Kathodenrückplatte wird mit vorverflüssigtem Bi57Sn43 gew.%-Lot mit Hilfe einer Stahlbürste benetzt. Auf der Kathodenrückplatte wird ein Lotüberschuß von 1,5 kg Bi57Sn43 gew.%-Lot aufgegossen. Das vorbenetzte Teil wird auf den Lotüberschuß der Kathodenrückplatte aufgelegt und mit Spannbügeln flächig auf die Kathodenrückplatte aufgedrückt. Das Sputtertarget wird zusammen mit der Kathodenrückplatte langsam auf Zimmertemperatur abgekühlt.
2. Ein Sputtertarget aus Sn80In20 gew.%, Länge 3694 mm, Breite 232 mm, Dicke 12 mm wird gleichmäßig auf 140 °C erwärmt. Die Kathodenrückplatte aus Kupfer wird auf 170°C erwärmt. Die Rückseite des Sputtertargets wird mit vorverflüssigtem Bi54Sn41In4Cul mit Hilfe eines fusselfreien und hitzebeständigen Tuchs benetzt. Die Kathodenrückplatte wird mit vorverflüssigtem Bi54Sn41In4Cul gew.%-Lot mit Hilfe einer Stahlbürste benetzt. Auf die Kathodenrückplatte wird ein Lotüberschuß von 1,5 kg Bi54Sn41In4Cul gew.%-Lot aufgegossen. Das vorbenetzt Target wird auf den Lotüberschuß der Kathodenrückplatte aufgelegt und mit Spannbügeln flächig auf die Kathodenrückplatte gedrückt. Das Sputtertarget wird zusammen mit der Kathodenrückplatte langsam auf Zimmertemperatur abgekühlt.
3. Eine Versuchsserie, bestehend aus 10 Zinn-Sputtertargets der Dimension 380x100x8 mm würde zur Hälfte nach dem üblichen Verfahren mit InSn-Legierung und zur Hälfte mit dem erfindungsgemäßen Verfahren gemäß Beispiel 1. flächig auf eine Kupferplatte gelötet. Von jedem Target wurden Ultraschallbilder zur Untersuchung der Fehlstellenhäufigkeit erstellt. Ferner wurden von jedem Target metallographische Schliffe zum Ermitteln der Loteindringtiefe hergestellt. Weiterhin wurden Temperaturbelastungstests zum Ermitteln des Erweichungspunktes des Lotes durchgeführt.

Die Vorteile gegenüber Targets mit herkömmlicher Lotverbindung ergeben sich aus der nachstehenden Tabelle.

| | Stand der Technik | Erfindungsgemäßes Target |
|---|---|---|
| Lot | InSn70/30 gew.% | BiSn 57/43 gew.% |
| Benetzungstemperatur Target | 170°C | 170°C |
| Fehlerhaft gelötete Fläche (%) | 4,2 % ± 2,1 % | 2,1 % ± 1,4 % |
| Erweichungspunkt | 126 ± 2°C | 148 ± 2°C |
| Eindringtiefe des Lots | 214 ± 36 µm | 289 ± 45 µm |

## Patentansprüche

1. Sputtertarget aus einer Zinn-Basislegierung mit einer mit dem abzusputternden Werkstoff durch Löten verbundenen Rückplatte, **dadurch gekennzeichnet**, daß das Lot aus den Legierungselementen Wismut mit 27 bis 68 gew.% und Zinn mit 32 bis 73 gew.% zuzüglich einem weiteren Anteil von kleiner 5 gew.% aus der Gruppe der Elemente Indium, Antimon, Blei, Silber oder Kupfer gebildet ist.

2. Sputtertarget nach Anspruch 1, **dadurch gekennzeichnet**, daß das Lot aus einem eutektischen Gefüge mit 57 gew.% Wismut und 43 gew.% Zinn gebildet ist.

## Claims

1. Sputtering target composed of a tin-based alloy having a back plate joined by soldering to the material to be sputtered off, characterised in that the solder is formed of the alloy elements bismuth comprising 27 to 68 wt. % and tin comprising 32 to 73 wt. % including a further component of less than 5 wt. % of the group of elements comprising indium, antimony, lead, silver or copper.

2. Sputtering target according to claim 1, characterised in that the solder is formed of a eutectic structure comprising 57 wt. % bismuth and 43 wt. % tin.

## Revendications

1. Cible de pulvérisation cathodique constituée par un alliage à base d'étain comportant une plaque dorsale liée par brasage au matériau devant être retiré par pulvérisation cathodique, caractérisée en ce que le métal d'apport de brasage est formé par les éléments d'alliage bismuth à raison de 27 à 68 % en masse et étain à raison de 32 à 73 % en masse plus une proportion supplémentaire inférieure à 5 % en masse du groupe des éléments indium, antimoine, plomb, argent ou cuivre.

2. Cible de pulvérisation cathodique selon la revendication 1, caractérisée en ce que le métal d'apport de brasage est formé par une structure eutectique comportant 57 % en masse de bismuth et 43 % en masse d'étain.
